# EUROPEAN PATENT APPLICATION

(11) **EP 0 793 126 A1**
(43) Date of publication of application: **03.09.1997**
(21) Application number: 97301362.6
(22) Date of filing: 28.02.1997
(51) Int. Cl.: G02B 6/42, H01S 3/025

(54) **Stabilised pump laser**

(30) Priority: 29.02.1996 GB 9604304
(71) Applicant: STC Submarine Systems Limited, London SE10 0AG (GB)
(72) Inventor: Dhooper, Jas, Bexleyheath, Kent DA7 5RB (GB); Spencer, Geoffrey, Fish Hoek, 7975 Cape Town (ZA)
(74) Representative: Vaufrouard, John Charles

(57) **Abstract**

A pump laser for an optical transmission system comprises the combination in a common housing (10) of a laser generator (12) and an optical fibre grating (24). The grating is coupled between the laser generator and a pump output from the housing.

The housing may have a holder to which the fibre is secured. The fibre may be secured to the holder by means of an epoxy adhesive or the fibre may have a metallised end section which is secured to the holder by soldering. Preferably the metallisation does not extend over the grating.

## Description

This invention relates to stabilised pump lasers such as are employed in optical signal transmission systems to provide pump power to for example erbium doped optical repeater amplifiers.

One of the requirements of such repeater amplifiers is for the pump wavelength to be a relatively pure coherent wavelength and with stable polarisation. One way of achieving this which is known to us is to include a fibre grating before the repeater amplifier. The grating improves the amplifier performance with temperature change which would otherwise have degraded.

The present invention seeks to optimise the stabilisation of pump wavelength.

According to the invention there is provided a pump laser for an optical transmission system, comprising the combination in a common housing of a laser generator and an optical fibre grating coupled between the laser generator and a pump output from the housing.

The optical fibre grating may be formed in a fibre which extends from a position close to the laser to permit optical coupling of the generated signal thereto. The optical fibre may form a laser tail which extends out of the housing for splicing to another fibre. The laser housing may have a ferrule through which the laser tail extends. The portion of optical fibre incorporating the grating may be arranged to extend into the ferrule.

The housing may have a holder to which the fibre is secured. The fibre may be secured to the holder by means of an epoxy adhesive or the fibre may have a metallised end section which is secured to the holder by soldering. Preferably the metallisation does not extend over the grating.

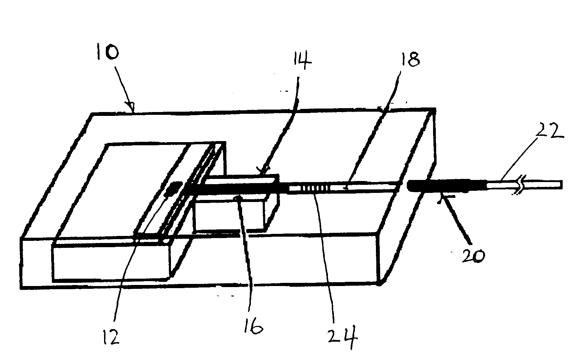

In order that the invention and its various other preferred features may be understood more easily, some embodiments thereof will now be described, by way of example only, with reference to the drawing, the single Figure of which is a schematic illustration of a pump laser and internal configuration which is constructed in accordance with the invention.

In the drawing a pump laser comprises a housing in which there is disposed a laser 12. Adjoining the laser there is provided a fibre holder 14 in the form of a block having a fixing area 16 for an optical fibre. An optical fibre 18 has one end located so as to permit communications of laser generated light into and along the fibre. The end of the fibre is secured onto the fixing area 16 of the fibre holder 14 by means of an adhesive e.g. an epoxy adhesive or alternatively the end of the fibre is metallised and secured to the fixing area 16 by soldering. In this way a good mechanical fixing is achieved. The fibre extends out of the housing via a metal ferrule and provides a fibre tail 22 for splicing to another fibre for coupling to an optical amplifier.

The optical fibre is provided with a built in fibre grating which is a varying refractive index written into the fibre in a known manner. The grating mode locks the laser by providing a weak (∼3%) reflection at the required pump wavelength. The approximate length of the grating is 100 to 200 cm and dependent upon the size of the housing the grating can be contained wholly within the main housing or can extend into the ferrule or could be housed entirely within the ferrule. In this way, the fibre grating can be positioned close to the laser safely within the housing and/or ferrule which stabilises the polarisation state appearing at the grating thereby minimising polarisation dependant loss in the grating. Such a construction provides an excellent mechanical housing eliminating external influences from damaging the grating in addition to minimising polarisation effects.

## Claims

1. A pump laser for an optical transmission system, comprising the combination in a common housing (10) of a laser generator (12) and an optical fibre grating (24) coupled between the laser generator and a pump output from the housing.

2. A pump laser as claimed in claim 1, wherein the optical fibre grating (24) is formed in a fibre (18) which extends from a position close to the laser (12) to permit optical coupling of the generated signal thereto.

3. A pump laser as claimed in claim 2, wherein the optical fibre (18) forms a laser tail (22) which extends out of the housing for splicing to another fibre.

4. A pump laser as claimed in claim 3, wherein the housing (10) has a ferrule (20) through which the laser tail (22) extends.

5. A pump laser as claimed in claim 4, wherein the portion of optical fibre incorporating the grating (24) extends into the ferrule (20).

6. A pump laser as claimed in any one of claims 2 to 5, wherein the housing (10) has a holder (14) to which the fibre is secured.

7. A pump laser as claimed in claim 6, wherein the fibre (18) is secured to the holder (14) by means of an epoxy adhesive.

8. A pump laser as claimed in claim 6, wherein the fibre (18) has a metallised end section which is secured to the holder (14) by soldering.

9. A pump laser as claimed in claim 8, wherein the metallisation does not extend over the grating (24).
